## Europäisches Patentamt
## European Patent Office
## Office européen des brevets

(19)

(11) Veröffentlichungsnummer : **0 173 761 B1**

(12) **EUROPÄISCHE PATENTSCHRIFT**

(45) Veröffentlichungstag der Patentschrift : 27.07.88

(51) Int. Cl.⁴ : **B 06 B   1/02**, H 03 L   7/02

(21) Anmeldenummer : **84110500.0**

(22) Anmeldetag : **04.09.84**

(54) Leistungsgenerator für einen Ultraschallwandler.

(43) Veröffentlichungstag der Anmeldung : **12.03.86 Patentblatt 86/11**

(45) Bekanntmachung des Hinweises auf die Patenterteilung : **27.07.88 Patentblatt 88/30**

(84) Benannte Vertragsstaaten : **AT BE CH DE FR GB IT LI NL SE**

(56) Entgegenhaltungen :
DE-A- 2 261 712
DE-B- 2 815 434
US-A- 3 489 930
US-A- 4 271 371
US-A- 4 445 063

(73) Patentinhaber : **MED inventio AG**
**Seestrasse 359**
**CH-8038 Zürich-Wollishofen (CH)**

(72) Erfinder : **Flachenecker, Gerhard, Prof. Dr.-Ing.**
**Bozener Strasse 8**
**D-8012 Ottobrunn (DE)**
Erfinder : **Fastenmeier, Karl, Prof. Dr.-Ing.**
**Lützelsteiner Strasse 7b**
**D-8000 München 45 (DE)**
Erfinder : **Lindenmeier, Heinz, Prof. Dr.-Ing.**
**Fürstenrieder Strasse 7**
**D-8033 Planegg (DE)**

(74) Vertreter : **Wenzel, Joachim, Dipl.-Ing.**
**Hauptmannsreute 46**
**D-7000 Stuttgart 1 (DE)**

# Beschreibung

Die Erfindung bezieht sich auf einen Leistungsgenerator für einen Ultraschallwandler entsprechend dem Oberbegriff des Anspruchs 1.

Ultraschallwandler werden in vielen Anwendungsfällen verwendet, in denen eine gewünschte Wirkung mit der Leistung einer Ultraschallwelle oder einer Ultraschallschwingung erzielt werden kann. Ein Beispiel sind Reinigungsgeräte, bei denen eine Reinigungsflüssigkeit durch einen Ultraschallwandler zu Ultraschallschwingungen angeregt wird, wodurch auch festhaftende Verunreinigungen von der Oberfläche eingetauchter Gegenstände abgelöst werden. Ein weiteres Beispiel sind Ultraschall-Schweißgeräte, bei denen die Verlustwärme genutzt wird, die bei Ultraschallschwingungen hoher Intensität in elastischen Materialien auftritt. In der Hochfrequenztechnik sind Ultraschallwandler z. B. zur Aussendung von gerichteten, modulierten Ultraschallwellen in Wasser bekannt, was zur Nachrichtenübertragung oder Ortung von Schiffen unter Wasser verwendet werden kann. In der Medizin werden Ultraschallwandler beispielsweise zur Zerstörung von Blasen- und Nierensteinen verwendet, da sich Ultraschallwellen hoher Intensität mit Wellenleitern relativ einfach durch natürliche Körperöffnungen (z. B. die Harnröhre) an die zu zerstörenden Steine heranführen lassen, wodurch die Steine ohne größere Operation entfernbar sind.

Ultraschallwandler werden als elektro-mechanische Wandler bezeichnet und können nach verschiedenen Prinzipien aufgebaut sein. Für hohe Leistungen werden bevorzugt Keramikscheiben verwendet, die nach dem umgekehrten piezoelektrischen Effekt arbeiten.

Im Betrieb werden Ultraschallwandler an eine mechanische Resonanzanordnung angekoppelt. Hohe Ausgangsleistungen mit gutem Wirkungsgrad sind in jedem Fall nur dann zu erreichen, wenn die Anordnung genau bei der Resonanzfrequenz der mechanischen Anordnung oder sehr nahe bei dieser arbeitet. Die elektrische Leistung, mit der der Ultraschallwandler gespeist wird, muß daher sehr genau mit der Arbeitsfrequenz der mechanischen Anordnung zugeführt werden. Da sich die Resonanzfrequenz der Anordnung im Betrieb, z. B. durch Erwärmung oder Laständerung, oder durch Alterungserscheinungen im Laufe der Lebensdauer ändern kann, muß der Leistungsgenerator, der den Ultraschallwandler ansteuert, von den Resonanzverhältnissen der mechanischen Anordnung geregelt werden. Man verwendet hierzu Phasenmeßeinrichtungen, die den Phasenunterschied zwischen der am Ultraschallwandler eingespeisten Spannung und dem eingespeisten Strom messen. Vom Ausgangssignal der Phasenmeßeinrichtung wird die Frequenz des Leistungsgenerators so nachgeregelt, daß Spannung und Strom am Ultraschallwandler eine vorgegebene Phasenverschiebung einhalten, d. h. im allgemeinen möglichst in Phase sind.

Eine bekannte Anordnung dieser Art ist in « The High-Frequency Generator for the Ultrasonic Lithotrite », IN-SIGHT, Urology Edition April 1983, published by Karl Storz Endoscopy-America, Inc., Culver City, CA/USA, beschrieben. Dabei handelt es sich um einen Hochfrequenz-Leistungsgenerator, der eine Ultraschallsonde für die Zertrümmerung von Blasensteinen speist. Der Hochfrequenzgenerator enthält einen spannungsgesteuerten Oszillator, der im anglo-amerikanischen als « voltage-entrolled oscillator » oder VCO bezeichnet wird. Dieser VCO kann mit einer angelegten Spannung in der Frequenz abgestimmt werden. Die Hochfrequenz-Ausgangsspannung des Oszillators wird von einem Leistungsverstärker verstärkt und dem Ultraschallwandler zugeführt. Eine Phasenmeßeinrichtung mißt am Ausgang des Verstärkers den Phasenunterschied zwischen dem Strom, der durch den Ultraschallwandler fließt, und der Spannung, die am Ultraschallwandler anliegt und gibt das Ausgangssignal an den VCO weiter. Dadurch wird die Frequenz des VCO laufend auf die Resonanzbedingung nachgestimmt.

Eine ähnliche Schaltung ist auch aus der US-A-4 271 371 bekannt.

Dieses Verfahren arbeitet jedoch nicht optimal. Aus der Anwendung des beschriebenen Leistungsgenerators ist bekannt, daß die Schwingung des Ultraschallwandlers manchmal « abreißt », das heißt, der VCO läuft trotz der Resonanzregelung auf eine völlig falsche Frequenz und der Ultraschallwandler gibt keine Leistung mehr ab. Dieses Verhalten wird insbesondere beobachtet, wenn die Belastung des Ultraschallwandlers schwankt, z. B. wenn der operierende Arzt die mit dem Ultraschallwandler verbundene Sonde zu stark an einen zu zerstörenden Blasenstein andrückt. Aus dem Herstellungsprozeß für den beschriebenen Leistungsgenerator ist weiterhin bekannt, daß beim Schlußabgleich der Phasenregelung nicht der Fall der Phasenverschiebung Null zwischen Strom und Spannung des Ultraschallwandlers, was dem Fachmann als Optimum erscheinen würde, eingestellt werden darf. In der Einstellung der Phasenverschiebung, die der Leistungsgenerator im Betrieb konstant regelt, muß vielmehr jedesmal ein Kompromiß gefunden werden zwischen möglichst großer Ausgangsleistung und Stabilität der abgegebenen Leistung. Es wird aber nie die maximal mögliche Leistung und absolute Stabilität der Schwingung gegen Lastschwankungen gleichzeitig erreicht.

Dieses Verhalten hat mehrere Gründe. Zunächst hat ein Ultraschallwandler ein Ersatzschaltbild, das als Serienschwingkreis aus einer Kapazität, einer Induktivität und einem ohm'schen Widerstand aufgebaut ist. Diesem Serienschwingkreis liegt eine Kapazität, die sog. Ruhekapazität des Ultraschallwandlers, parallel. Mit sich ändernder Belastung ändert sich der Wert des ohm'schen Widerstandes im Serienschwingkreis. Bei der kleinsten Belastung ist dieser Widerstand am kleinsten, mit steigender Belastung steigt sein Wert ebenfalls an.

Weiterhin ist in der Praxis der Ultraschallwandler, wie z. B. im Fall der Ultraschall-Blasensteinzertrümmerung, vom Leistungsgenerator räumlich getrennt. Die Entfernung muß mit einer Zuleitung überbrückt werden, deren Kapazität eine weitere Parallelkapazität zum Ultraschallwandler ergibt. Die elektrische Impedanz des gesamten am Leistungsgenerator angeschlossenen Ultraschallwandlers einschließlich Zuleitung hat daher bei der eigentlichen Resonanz der mechanischen Anordnung nicht mehr den Phasenwinkel Null. Der Phasenwinkel der elektrischen Impedanz hat bei der Resonanzfrequenz der mechanischen Anordnung nicht einmal einen konstanten Wert, wenn sich die Belastung ändert. Eine feste Einstellung der Phasenregelung kann daher maximal für einen einzigen Belastungswert die optimale Ausgangsleistung ergeben. Bei jeder anderen Belastung beeinflußt die Phasenregelung den VCO so, daß die Frequenz aus der Resonanz der mechanischen Anordnung mehr oder weniger weit herausläuft.

Die Ortskurve der Eingangsimpedanz eines Ultraschallwandlers mit Ruhekapazität und Zuleitungskapazität ist im Bereich der Resonanzfrequenz nicht symmetrisch zur reellen Achse. Sie wird umso unsymmetrischer, je größer die Belastung wird und kann dabei so stark in die kapazitive Halbebene wandern, daß im Bereich der Resonanzschleife überhaupt kein Wert mehr existiert, bei dem die Phase zwischen Strom und Spannung den Wert hat, auf den die Phasenregelung eingestellt ist. Bei einer solchen Belastung reißt die Schwingung ab, der Ultraschallwandler gibt keine Leistung mehr ab.

Der Erfindung liegt die Aufgabe zugrunde, einen Leistungsgenerator für einen Ultraschallwandler zu schaffen, bei dem die Phasenregelung so eingestellt werden kann, daß die maximal mögliche Ausgangsleistung des Leistungsgenerators und die höchstmögliche Schwingungsstabilität bei Lastschwankungen gleichzeitig erreicht werden.

Zur Lösung dieser Aufgabe werden erfindungsgemäß die in den Kennzeichen der Ansprüche angegebenen Maßnahmen vorgeschlagen. Insbesondere wird dabei das zweite Eingangssignal der Phasenmeßeinrichtung, mit dem die Phase des Stromes durch den Ultraschallwandler gemessen wird, von einem Übertrager mit drei Wicklungen abgleitet. Durch die erste Wicklung des Übertragers fließt der Strom, der dem Ultraschallwandler insgesamt zugeführt wird, oder ein proportionaler Anteil davon. Durch die zweite Wicklung dieses Übertragers fließt ein Strom, der dem von der Zuleitungskapazität und der Ruhekapazität des Ultraschallwandlers verursachten Blindstrom gleich oder proportional ist. Dabei sind die erste und die zweite Wicklung so gepolt, daß sich ihre magnetischen Wirkungen auf den Kern des Übertragers voneinander abziehen. Auf den Kern wirkt dabei eine magnetische Spannung, die dem reinen Wirkstrom proportional ist, der durch den Wirkwiderstand im Ersatschaltbild des Ultraschallwandlers fließt. Von einer dritten Wicklung auf diesem Übertrager kann daher ein Signal abgenommen werden, das dem reinen Wirkstrom des Ultraschallwandlers proportional ist und insbesondere dessen Phase besitzt. Wird dieses Signal der Phasenmeßeinrichtung als Phasensignal für den Strom des Ultraschallwandlers zugeführt, so kann die Resonanzüberwachung ohne die störenden Einflüsse der Zuleitungsinduktivität und der Ruhekapazität des Ultraschallwandlers durchgeführt werden. Dabei kann die Phase zwischen der Spannung am Ultraschallwandler und seinem Wirkstrom ohne Rücksicht auf die Belastung konstant und sogar exakt zu null Grad geregelt werden.

In einer vorteilhaften Ausgestaltung der Erfindung ist die erste Wicklung des Übertragers in Serie zu dem angeschalteten Ultraschallwandler geschaltet. In Serie zu der zweiten Wicklung des Übertragers ist ein Kondensator geschaltet. Die beiden so entstandenen Serienschaltungen sind parallel geschaltet und direkt oder über bekannte Ankopplungsschaltungen an den Ausgang des Leistungsverstärkers angeschaltet. Dabei ist der in Serie zur zweiten Wicklung liegende Kondensator so dimensioniert, daß das Verhältnis seiner Kapazität zur Summe aus Zuleitungskapazität und Ruhekapazität des Ultraschallwandlers ungefähr reziprok proportional ist zum Verhältnis der Windungszahlen der zweiten und der ersten Wicklung. Bei dieser Dimensionierung kompensieren sich für die Phasenmessung im Kern des Übertragers die Wirkungen der Zuleitungs- und der Ruhekapazität frequenzunabhängig nahezu vollständig.

Wird die Kapazität des Kondensators ungefähr so groß wie die Summe aus der Zuleitungskapazität und der Ruhekapazität des Ultraschallwandlers gewählt und haben die erste und die zweite Wicklung des Übertragers gleich große Windungszahl, so erhält man eine weitere vorteilhafte Ausgestaltung der Erfindung.

Weitere vorteilhafte Ausgestaltungen der Erfindung sind in den Kennzeichen der weiteren Unteransprüche vorgeschlagen. Um eine möglichst verlustarme Anschaltung des Ultraschallwandlers an den Leistungsgenerator zu erreichen, muß die Induktivität der ersten Wicklung des Übertragers so klein wie möglich gehalten werden. Man kann dies am besten realisieren, wenn man für den Übertrager eine möglichst streuarme Ausführung des Kernes verwendet. In diesem Fall kann mit sehr kleinen Windungszahlen und damit sehr kleinen Induktivitätswerten gearbeitet werden. Erfindungsgemäß wird für den Übertrager ein Ringkern vorgeschlagen. Man kann damit für die erste und die zweite Wicklung bis zur Windungszahl eins heruntergehen. Beim Ringkern bedeutet dies für die erste und zweite Wicklung je eine durch den Ringkern je einmal hindurchgeführte Leitung.

Zur Verdeutlichung der Erfindung sind folgende Zeichnungen beigefügt. Es zeigen :

Fig. 1 Blockschaltbild eines erfindungsgemäßen Leistungsgenerators mit dem aus drei Wicklungen bestehenden Übertrager und der Ersatzschaltung eines angeschalteten Ultraschallwandlers mit Zuleitungskapazität.

Fig. 2 Ortskurven der Eingangsimpedanz eines Ultraschallwandlers bei verschiedenen Werten der Belastung und mit Berücksichtigung der Zuleitungs- und der Ruhekapazität.

Fig. 3 Ausführungsbeispiel eines Übertragers mit drei Wicklungen, dessen Kern als Ringkern ausgeführt ist.

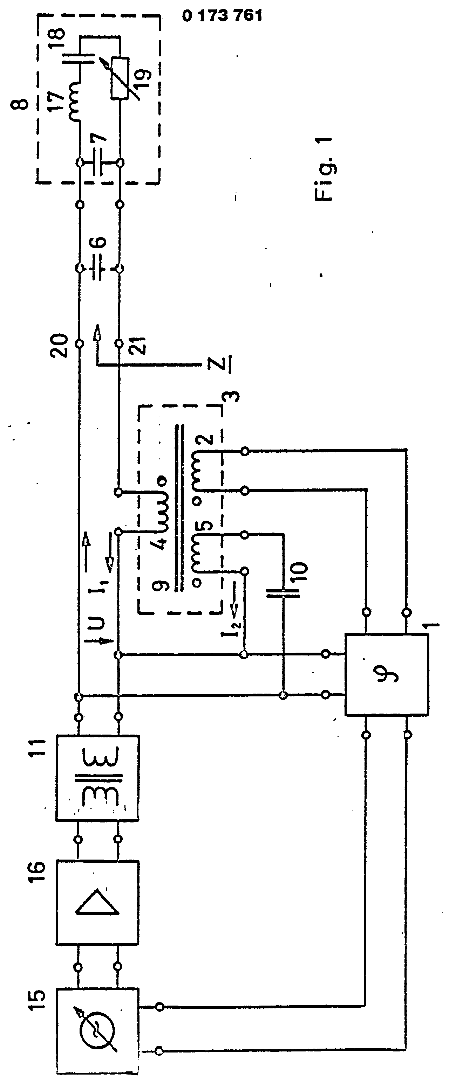

In Fig. 1 ist das Blockschaltbild eines erfindungsgemäßen Leistungsgenerators mit dem aus drei Wicklungen bestehenden Übertrager dargestellt. Der VCO 15 speist einen Leistungsverstärker 16 an dessen Ausgang in diesem Beispiel ein Ankopplungsvierpol 11 angeschaltet ist. Ein solcher Ankopplungsvierpol kann in bekannter Weise Verwendung finden, wenn z. B. der Verstärker im Gegentaktprinzip arbeitet und die Ausgänge der beiden Verstärkerhälften zusammengeschaltet werden müssen. Er kann aber auch zur Leistungsanpassung dienen. Im allgemeinen ist ein solcher Ankopplungsvierpol als Übertrager mit hohem Kopplungsfaktor realisiert. An den Ausgang des möglicherweise verwendeten Ankopplungsvierpols ist zunächst die Serienschaltung aus dem Ultraschallwandler 8 und der ersten Wicklung 4 des Übertragers 3 geschaltet. Parallel zum Ultraschallwandler 8 liegt dabei noch die Zuleitungskapazität 6.

Am Ausgang des Ankopplungsvierpols 11 ist weiterhin die Serienschaltung aus der zweiten Wicklung 5 des Übertragers 3 und der Kapazität 10 angeschaltet. Zusätzlich wird am Ausgang des Ankopplungsvierpols 11 die Spannung U als erstes Eingangssignal für die Phasenmeßeinrichtung 1 abgegriffen. Auf dem Kern 9 des Übertragers 3 ist noch eine dritte Wicklung 2 angeordnet. Von ihr wird das zweite Eingangssignal für die Phasenmeßeinrichtung 1 abgegriffen.

Die Phasenmeßeinrichtung 1 kann nach jedem der bekannten Prinzipien arbeiten. Sie muß nur einen geeigneten Zusammenhang zwischen ihrer Ausgangsspannung und dem Phasenunterschied zwischen den beiden Eingangssignalen herstellen. Die Phasenmeßeinrichtung wird im allgemeinen einen Sollwertvergleicher und einen Regelverstärker mit geeigneter Charakteristik enthalten, damit die Regelschleife stabil arbeitet und den Phasenunterschied zwischen den beiden Eingangssignalen der Phasenmeßeinrichtung konstant auf den vorgegebenen Sollwert regelt.

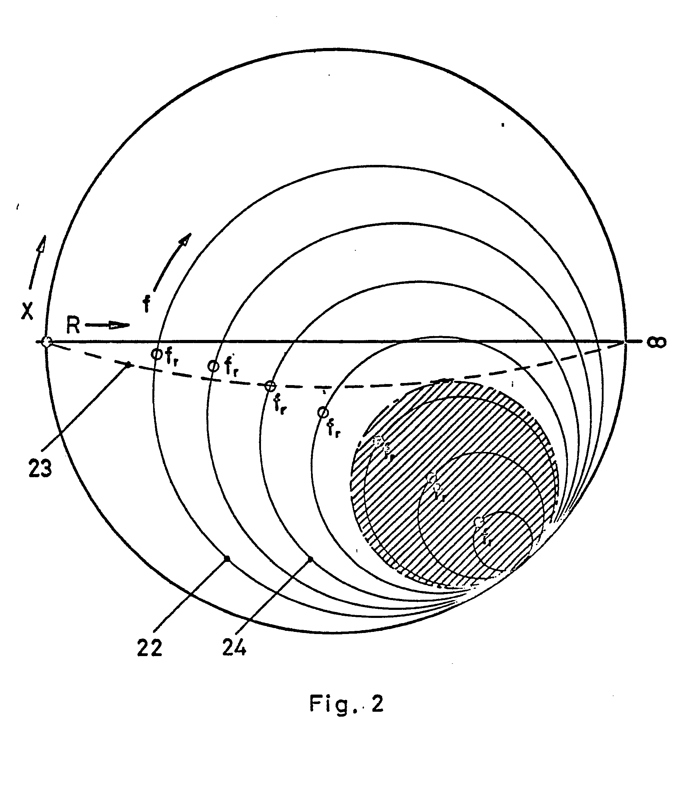

Fig. 2 zeigt in einem Smith-Diagramm Ortskurven der Eingangsimpedanz Z eines Ultraschallwandlers mit Zuleitung im Bereich der Resonanzfrequenz, wie sie z. B. zwischen den Klemmen 20 und 21 in Fig. 2 gemessen werden würden. Der Parameter der Kurven ist die Belastung. Die Ortskurve 22 mit dem größten Durchmesser beschreibt den unbelasteten Fall. Die in dieser Ortskurve enthaltenen Realteile der Impedanz sind nur auf die Eigenverluste des Ultraschallwandlers und der angekoppelten mechanischen Resonanzanordnung zurückzuführen. Die Ortskurven mit kleineren Durchmessern entstehen bei wachsender Belastung des Ultraschallschwingers.

Auf jeder Ortskurve ist mit einem Kreis die Resonanzfrequenz fr der mechanischen Resonanz markiert. Mit dieser Frequenz müßte der Leistungsgenerator jedesmal seine Leistung abgeben, um bei jeder Belastung die maximal mögliche Ultraschall-Leistung zu erzeugen. Wie man Fig. 2 entnimmt, hat die elektrische Eingangsimpedanz des Ultraschallwandlers aber bei der mechanischen Resonanzfrequenz bei jeder Belastung einen anderen Phasenwinkel. Wird daher die Phasenregelung eines Leistungsgenerators ohne die erfindungsgemäße Ausgestaltung auf einen konstanten Phasenwinkel zwischen Spannung und Strom im Ultraschallwandler eingestellt, so kann diese Regelung nur bei einer Belastung die maximal mögliche Ultraschall-Leistung ergeben. In Fig. 2 ist dieser Fall für ein Beispiel dargestellt. Die strichlierte Kurve 23 ist im Smith-Diagramm eine Kurve konstanter Phase der Impedanz. Ist die Phasenregelung auf den Wert dieses Beispiels eingestellt, so wird der Ultraschallwandler nur im dritten dargestellten Belastungsfall mit der Ortskurve 24 bei der mechanischen Resonanz betrieben, bei allen anderen Belastungen aber nicht.

Darüber hinaus zeigt Fig. 2, daß ab einer bestimmten Belastung die Ortskurven der Eingangsimpedanz Z den eingestellten Phasenwinkel gar nicht mehr schneiden. In diesem Belastungsbereich, in Fig. 2 schraffiert dargestellt, gibt ein Leistungsgenerator ohne die erfindungsgemäße Ausgestaltung überhaupt keine Leistung mehr ab, die Ultraschall-Schwingung reißt ab. Ein solcher Generator kann daher immer nur auf einen Kompromiß zwischen Leistungsfähigkeit bei einer bestimmten Belastung und Stabilität eingestellt werden.

Ein Leistungsgenerator nach der Erfindung vermeidet dagegen die Effekte der Zuleitungskapazität und der Ruhekapazität des Ultraschallwandlers, weil die damit verbundenen Blindströme im Meßzweig der Stromphase mit Hilfe der vorgeschlagenen Maßnahme kompensiert werden. Ein Generator mit den Merkmalen der Erfindung kann optimal auf die mechanische Resonanz des Ultraschallwandlers eingestellt werden, und diese Einstellung bleibt bei jeder Belastung erhalten. Außerdem reißt die Ultraschallschwingung bei optimaler Leistungseinstellung bei keiner Belastung ab.

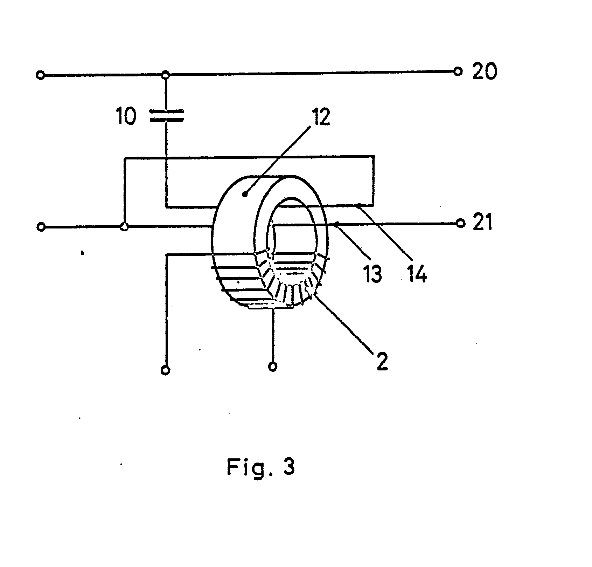

In Fig. 3 ist ein besonders vorteilhaftes Ausführungsbeispiel eines erfindungsgemäßen Übertragers mit drei Wicklungen gezeigt. In diesem Beispiel ist der Kern des Übertragers als Ringkern ausgeführt, der besonders streuarm ist und damit kleine Induktivitäten für die erste und die zweite Wicklung realisierbar macht. In diesem Fall ist die erste und die zweite Wicklung jeweils als nur eine Windung ausgeführt, was im Fall des Ringkerns je einen lediglich einmal durch den Ringkern geführten Leiter bedeutet.

## Patentansprüche

1. Leistungsgenerator für einen Ultraschallwandler (8), bestehend aus einem spannungsgesteuerten Oszillator (15) mit Leistungsverstärken (16), an dem der Ultraschallwandler (8) über bekannte Ankopplungsschaltungen angeschlossen ist, und einer Phasenmeßeinrichtung (1), wobei das Ausgangssignal der Phasenmeßeinrichtung (1) die Frequenzabstimmung des Oszillators (15) durchführt und das erste Eingangssignal der Phasenmeßeinrichtung aus der am angeschlossenen Ultraschallwandler anstehenden Spannung abgeleitet ist und das zweite Eingangssignal der Phasenmeßeinrichtung aus dem durch den angeschlossenen Ultraschallwandler fließenden Laststrom abgeleitet ist, dadurch gekennzeichnet, daß das zweite Eingangssignal der Phasenmeßeinrichtung (1) aus der dritten Wicklung (2) eines Übertragers (3) mit drei Wicklungen gewonnen wird, wobei die erste Wicklung (4) des Übertragers (3) vom Laststrom (I1) oder einem proportionalen Anteil des Laststroms (I1) durchflossen wird, und seine zweite Wicklung (5) von einem Strom durchflossen wird, der gleich oder proportional dem im Laststrom enthaltenen, von der Zuleitungskapazität (6) und der Ruhekapazität (7) des Ultraschallwandlers (8) verursachten Blindstrom ist, und die erste und die zweite Wicklung so gepolt sind, daß sich ihre magnetischen Wirkungen auf den Kern (9) des Übertragers (3) voneinander abziehen.

2. Leistungsgenerator für einen Ultraschallwandler nach Anspruch 1, dadurch gekennzeichnet, daß die erste Wicklung (4) des Übertragers (3) in Serie zu dem angeschalteten Ultraschallwandler (8) geschaltet ist, und in Serie zu der zweiten Wicklung (5) des Übertragers (3) ein Kondensator (10) geschaltet ist, und diese zwei Serienschaltungen parallel geschaltet und direkt oder über bekannte Ankopplungsschaltungen (11) an den Ausgang des Leistungsverstärkers angeschaltet sind, wobei der Kondensator (10) so dimensioniert ist, daß das Verhältnis seiner Kapazität zur Summe aus Zuleitungskapazität (6) und Ruhekapazität (7) des Ultraschallwandlers (8) ungefähr reziprok proportional ist zum Verhältnis der Windungszahlen der zweiten und der ersten Wicklung (5 und 4).

3. Leistungsgenerator für einen Ultraschallwandler nach Anspruch 2, dadurch gekennzeichnet, daß die Kapazität des Kondensators (10) ungefähr so groß ist wie die Summe aus der Zuleitungskapazität (6) und der Ruhekapazität (7) des Ultraschallwandlers (8), und daß die Windungszahlen der ersten Wicklung (4) und der zweiten Wicklung (5) des Übertragers (3) gleich groß sind.

4. Leistungsgenerator für einen Ultraschallwandler nach Anspruch 3, dadurch gekennzeichnet, daß der Kern (9) des Übertragers (3) als Ringkern (12) ausgebildet ist.

5. Leistungsgenerator für einen Ultraschallwandler nach Anspruch 3 oder 4, dadurch gekennzeichnet, daß die erste und die zweite Wicklung (4 und 5) des Übertragers (3) aus je einer Windung aufgebaut sind.

6. Leistungsgenerator für einen Ultraschallwandler nach Anspruch 4, dadurch gekennzeichnet, daß die erste und die zweite Wicklung (4 und 5) des Übertragers (3) aus je einem durch den Ringkern (12) gesteckten Leiter (13 und 14) bestehen.

## Claims

1. Power generator for an ultrasonic transducer (8) comprising a voltage-controlled oscillator (15) with power amplifier (16), to which is connected the ultrasonic transducer (8) by means of known coupling circuits, and a phase measuring device (1), the output signal of the phase measuring device (1) performing the frequency matching of oscillator (15) and the first input signal of the phase measuring device is derived from the voltage at the connected ultrasonic transducer and the second input signal of the phase measuring device is derived from the load current flowing through the connected ultrasonic transducer, characterized in that the second input signal of the phase measuring device (1) is obtained from the third winding (2) of a transformer (3) with three windings, the load current (I1) or a proportion of the load current (I1) flowing through the first winding (4) of transformer (3) and a current flows through its second winding (5) which is the same or proportional to the reactive current contained in the load current and caused by the lead capacitance (6) and the standby capacitance (7) of the ultrasonic transducer (8) and the first and second windings are poled in such a way that their magnetic actions on the core (9) of transformer (3) pull away from one another.

2. Power generator for an ultrasonic transducer according to claim 1, characterized in that the first winding (4) of transformer (3) is connected in series with the connected ultrasonic transducer (8) and a capacitor (10) is connected in series with the second winding (5) of transformer (3) and these two series connections are connected in parallel and directly or via known coupling circuits (11) to the output of the power amplifier, the capacitor (10) being dimensioned in such a way that the ratio of its capacitance to the sum of the lead capacitance (6) and the standby capacitance (7) of ultrasonic transducer (8) is approximately reciprocally proportional to the ratio of the number of turns of the second and first windings (5, 4).

3. Power generator for an ultrasonic transducer according to claim 2, characterized in that the capacitance of capacitor (10) is approximately as large as the sum of the standby capacitance (7) and the lead capacitance (6) of ultrasonic transducer (8) and that the number of turns of the first winding (4) and the second winding (5) of transformer (3) are equal.

4. Power generator for an ultrasonic transducer according to Claim 3, characterized in that the core (9) of transformer (3) is constructed as a ring core (12).

5. Power generator for an ultrasonic transducer according to claims 3 or 4, characterized in that the first and second windings (4, 5) of transformer (3) are formed by in each case one turn.

6. Power generator for an ultrasonic transducer according to claim 4, characterized in that the first and second windings (4, 5) of transformer (3) in each case comprise a conductor (13, 14) inserted through ring core (12).

**Revendications**

1. Générateur de puissance pour un convertisseur à ultra-sons (8), composé d'un oscillateur (15) commandé en tension, avec un amplificateur de puissance (16) auquel est raccordé le convertisseur à ultra-sons (8) au moyen de branchements de couplage connus et d'un dispositif de mesure de phase (1), le signal de sortie du dispositif de mesure de phase (1) exécutant à cette occasion la détermination de fréquence de l'oscillateur (15) et le premier signal d'entrée du dispositif de mesure de phase étant dérivé de la tension existant au convertisseur à ultra-sons qui est raccordé et le deuxième signal d'entrée du dispositif de mesure de phase étant dérivé du courant de charge qui s'écoule à travers le convertisseur à ultra-sons qui est raccordé, caractérisé en ce que le deuxième signal d'entrée du dispositif de mesure de phase (1) est obtenu à partir du troisième enroulement (2) d'un transformateur (3) à trois enroulements, le premier enroulement (4) du transformateur (3) étant à cette occasion parcouru par le courant de charge (I1) ou bien une partie proportionnelle du courant de charge (I1) et son deuxième enroulement (5) étant parcouru par un courant qui est identique ou bien proportionnel au courant réactif qui est contenu dans le courant de charge et est provoqué par la capacité d'alimentation (6) et la capacité de repos (7) du convertisseur à ultra-sons (8), et le premier et le deuxième enroulement ayant une polarité telle que leurs enroulements magnétiques se soustraient l'un de l'autre, sur le noyau (6) du transformateur (3).

2. Générateur de puissance pour un convertisseur selon la revendication 1, caractérisé en ce que le premier enroulement (4) du transformateur (3) est branché en série par rapport au convertisseur à ultra-sons (8) qui est branché et qu'un condensateur (10) est branché en série, par rapport au deuxième enroulement (5) du transformateur (3) et que ces deux branchements en série sont branchés en parallèle et qu'ils sont raccordés à la sortie de l'amplificateur de puissance, directement ou bien par des branchements de couplage (11) connus, le condensateur (10) étant, à cette occasion, dimensionné, de telle sorte que le rapport de sa capacité à la somme de capacité d'alimentation (6) et de la capacité de repos (7) du convertisseur à ultra-sons (8) est approximativement réciproquement proportionnelle au rapport des nombres d'enroulements du deuxième et du troisième enroulement (5 et 4).

3. Générateur de puissance pour un convertisseur à ultra-sons selon la revendication 2, caractérisé en ce que la capacité du condensateur (10) est approximativement de même importance que la somme de la capacité d'alimentation (6) et de la capacité de repos (7) du convertisseur à ultra-sons (8) et que les nombres d'enroulements du premier enroulement (4) et du deuxième enroulement (5) du transformateur (3) sont égaux.

4. Générateur de puissance pour un convertisseur à ultra-sons selon la revendication 3, caractérisé en ce que le noyau (9) du transformateur (3) est configuré en noyau annulaire (12).

5. Générateur de puissance pour un convertisseur à ultra-sons selon l'une quelconque des revendications 3 ou 4, caractérisé en ce que le premier et le deuxième enroulement (4 et 5) du transformateur (3) sont construits chacun en un enroulement.

6. Générateur de puissance pour un convertisseur à ultra-sons selon la revendication 4, caractérisé en ce que le premier et le deuxième enroulement (4 et 5) du transformateur (3) sont composés chacun d'un conducteur (13 et 14) enfiché à travers le noyau annulaire (12).

Fig. 1

0 173 761

Fig. 2

Fig. 3